# EUROPEAN PATENT APPLICATION

(11) **EP 0 547 286 A1**
(43) Date of publication of application: **23.06.1993**
(21) Application number: 92110895.7
(22) Date of filing: 26.06.1992
(51) Int. Cl.: H01R 13/633, G06K 7/06, H05K 7/14

(54) **Ejector system for an IC pack connector apparatus**

(30) Priority: 16.12.1991 EP 91121499
(71) Applicant: MOLEX INCORPORATED, Lisle Illinois 60532 (US)
(72) Inventor: O'Brien Paul M., Kilrush Co. Clare (IE); Previato, Mario, I-35100 Padova (IT)
(74) Representative: Blumbach, Kramer & Partner

(57) **Abstract**

An ejector mechanism is disclosed for use with a connector apparatus which includes a housing into which an IC pack is loaded and from which it is ejected. The three part ejector mechanism includes a one-piece eject lever and a one-piece actuator. The eject lever is pivotally mounted on the housing for ejecting the IC pack from the housing. The actuator lever is movably mounted within an integrally molded channel on the housing and is engageable with the eject lever to effect actuation thereof. Complementary interengaging portions of the housing, the eject lever and the actuator cooperate to effect the relative movements therebetween without the need of any extraneous components.

## Description

### Field of the Invention

This invention generally relates to the art of electrical connectors and, particularly, to a connector apparatus having a header connector adapted for receiving a memory card or IC pack, with means on the connector apparatus for ejecting the IC pack therefrom.

### Background of the Invention

Header connectors are used with memory cards or IC packs and are provided with various attachments, such as means for facilitating ejection or removal of the IC pack for replacement. The header connector is used for interconnecting the semiconductor circuit of the IC pack to an external circuit such as a main electronic unit. The IC pack is inserted into the header connector and is extracted therefrom as needed. The extraction force of the IC pack, i.e. the force between the respective terminal pins on the header connector and the respective terminals of the IC pack, is relatively high due to the tight fit required to obtain a good electrical interconnection between the terminals. These terminals typically are disposed at a high density which increases the extraction forces further. Often, when an IC pack is to be extracted from a header assembly, the card is grasped by a user and pulled out.

Consequently, a variety of ejecting mechanisms have been incorporated in various connector apparatus for facilitating ejecting an IC pack from a header connector. One of the problems with prior ejecting mechanisms is that they typically consist of multi-piece designs including springs, cams and sliders and either are costly to assemble or require special features on the card or header assembly. There is a definite need for a simple, low cost, easy to assemble IC pack ejector mechanism of the character described.

This invention is directed to solving the above problems and satisfying the need for a very simple and low cost ejecting system of the character described.

### Summary of the Invention

An object, therefore, of the invention is to provide a new and improved, simple ejecting system in a connector apparatus for ejecting an IC pack from a header connector.

In the exemplary embodiment of the invention, a connector apparatus includes a header connector into which an IC pack is loaded and from which it is ejected. An improved ejector system is provided of only three basic components: a housing which receives and guides an IC pack into mating engagement with the header terminals, a one-piece eject lever and a one-piece manually manipulatable actuator.

Specifically, the ejecting lever is movably mounted on the housing for ejecting the IC pack. The actuator member is movably mounted within an integrally molded channel on the housing for actuating the eject lever to eject the IC pack from the header connector. Complementary interengaging drive means between the eject lever and the actuator effect actuation of the eject lever in response to manual manipulation of the actuating member. The ejecting lever is pivotally mounted to the housing by integrally molded, complementary interengaging motion transmitting means. The lever is mounted to the housing intermediate opposite ends thereof. One end of the lever is engageable by the actuator, and the opposite end of the lever has an integral portion adapted to engage and effect ejection of the IC pack from the header connector. The actuator is provided in the form of an elongated push-rod movably mounted within an integrally molded channel on the housing. One end of the push-rod is engageable with the one end of the lever. The housing, the ejecting lever and the actuator all are individually molded of dielectric material such as plastic or the like. The complementary interengaging drive means are integrally molded with the eject lever and the actuator. Similarly, the complementary interengaging motion transmitting means are integrally molded with and interconnect the housing and the eject lever.

In one embodiment of the invention, the header connector itself incorporates the housing on which the eject lever is mounted and within which the actuator is positioned. The entire connector apparatus therefore consists of three components, one of which is the connector header itself.

In another embodiment of the invention, the housing is separate and distinct from the connector header, and the three piece eject mechanism is therefore latchably retrofittable onto a standard header connector. This embodiment allows the eject mechanism to be removed or added subsequent to soldering the header connector to a printed circuit board.

Other objects, features and advantages of the invention will be apparent from the following detailed description taken in connection with the accompanying drawings.

### Brief Description of the Drawings

The features of this invention which are believed to be novel are set forth with particularity in the appended claims. The invention, together with its objects and the advantages thereof, may be best understood by reference to the following description taken in conjunction with the accompanying drawings, in which like reference numerals identify like elements in the figures and in which:
FIGURE 1 is a perspective view of the three-part connector apparatus embodying the ejector system of a first embodiment of the invention.
FIGURE 2 is a top plan view of the apparatus;
FIGURE 3 is a side elevational view of the apparatus, looking toward the left-hand side of Figure 1;
FIGURE 4 is an end elevational view of the apparatus, looking in the direction of the top of Figure 1, and with the memory card removed;
FIGURE 5 is a plan view of the ejecting lever of the apparatus;
FIGURE 6 is an elevational view of the ejecting lever of Figure 5; and
FIGURE 7 is a bottom plan view of the apparatus, with the memory card being ejected from the header connector.
FIGURE 8 is a perspective view of a second embodiment of the invention in assembled condition;
FIGURE 9 is a perspective view of a header connector for receiving the ejector mechanism of Figure 8;
FIGURE 10 is an exploded perspective view of the three-part ejector mechanism shown in Figure 8;
FIGURE 11 is a top plan view of the actuating push-rod of the ejector mechanism, as viewed in Figure 10;
FIGURE 12 is a side elevational view of the push-rod of Figure 11;
FIGURE 13 is a top plan view of the ejecting lever of the ejector mechanism, as viewed in Figure 10; and
FIGURE 14 is a side elevational view of the ejecting lever of Figure 13.

### Detailed Description of the Preferred Embodiments

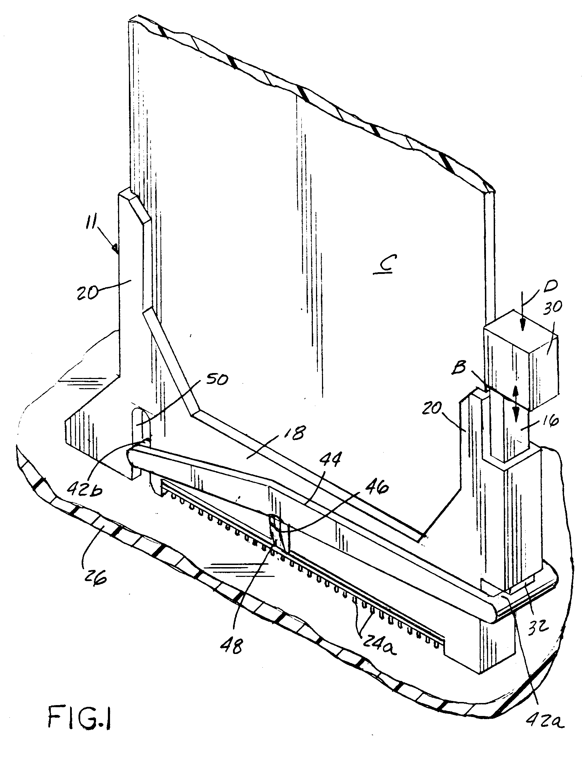

Referring to the drawings in greater detail, and first to Figure 1, the ejector system of the invention is embodied in a three-part ejector mechanism, generally designated 10. The mechanism is designed for incorporation directly in a connector apparatus which includes a header connector, generally designated 11, into which a memory card or IC pack "C" is loaded and from which it is ejected.

Generally, ejector mechanism 10 includes a first part in the form of a housing, generally designated 12, of header connector 11; a second part in the form of a one-piece eject lever, generally designated 14; and a third part in the form of a one-piece actuating push-rod, generally designated 16. Each of header connector housing 12, lever 14, and push-rod 16 is individually and integrally molded of dielectric material such as plastic or the like. No other extraneous components are required to assemble or to operate the mechanism.

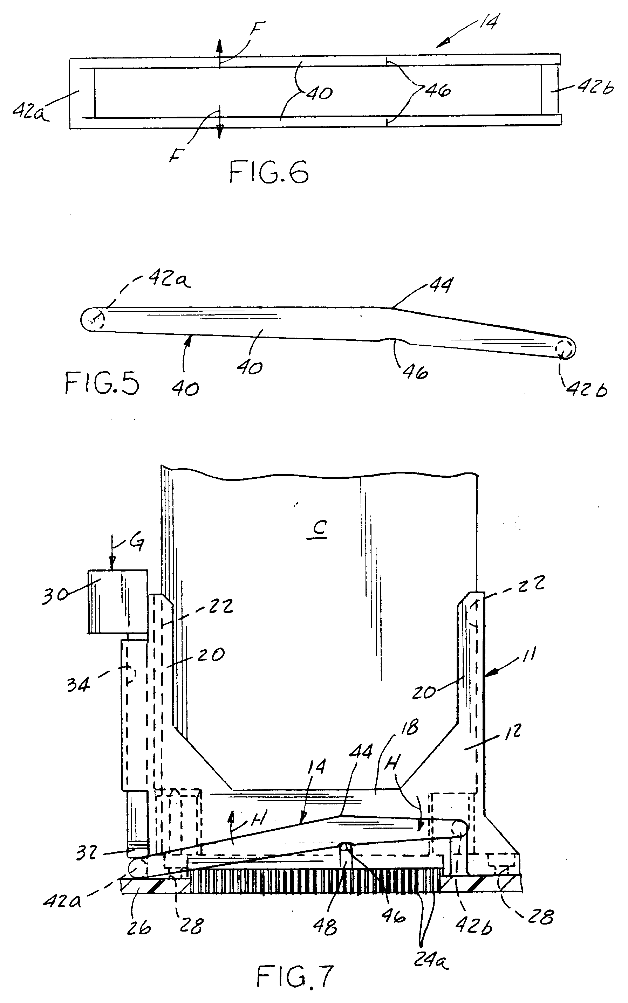

More particularly, header connector housing 12 is unitarily molded of plastic material and includes a pair of generally planar, elongated body portions 18 and two side wing portions 20 whereby the housing is generally U-shaped as seen best in Figure 1. Side wings 20 define inwardly directed channels 22 into which a memory card or IC pack "C" is inserted in the direction of arrow "A". Elongated body portion 18 is adapted for mounting a plurality of terminals having tail portions 24a for insertion into appropriate holes in a printed circuit board 26 whereby the tails can be interconnected, as by soldering, to appropriate circuit traces on the printed circuit board or in the terminal-receiving holes. This is seen best in Figures 1 and 2. Figure 4 shows that the terminals have pins 24b projecting from the side of body portion 18 opposite from tails 24a. The pins adapted to interconnect with terminals on IC pack "C" when the IC pack is inserted into the header connector. Lastly, housing 12 of header connector 11 includes a pair of apertures (Fig. 4) through which appropriate fastening means can be inserted to fasten the connector apparatus to printed circuit board 26.

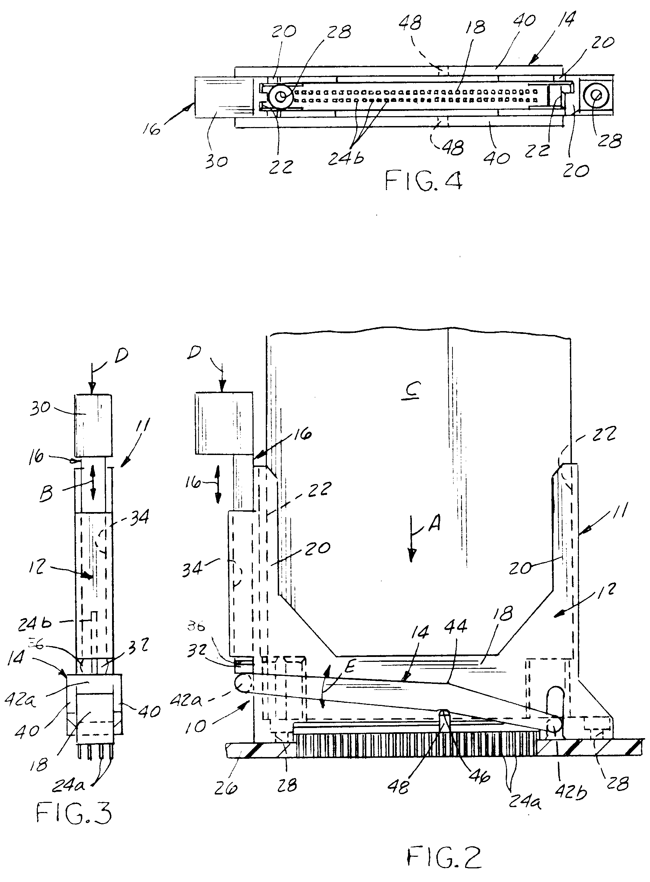

Actuating push-rod 16 includes a head portion or push-button 30 at one end thereof and a drive end 32 at the opposite end thereof. The drive end forms part of a complementary interengaging drive means between the push-rod and eject lever 14, as will be seen below. The push-rod is positioned in a closed channel 34 molded integrally with and projecting outwardly from the right-hand side wing 20 of header connector housing 12 as viewed in Figure 1. Push-button 30 of the push-rod is exposed at the front of housing 12 (the top as viewed in Figures 2 and 3), and the drive end 32 of the push-rod projects out of the rear of closed channel 34 for complementary interengagement with eject lever 14. Consequently, the push-rod is reciprocally mounted for movement in the direction of double-headed arrow "B". The push-rod is manually manipulatable by a user pushing on push-button 30 in the direction of arrows "D". Drive end 32 of the push-rod is bifurcated, as seen in Figure 3, and defines shoulders 36 which snap outwardly of the adjacent end of channel 34 to retain the push-rod on the housing within the channel.

Referring to Figures 5 and 6 in conjunction with Figures 1-4, eject lever 14 is elongated and includes a pair of generally parallel arm portions 40 which are spaced apart at opposite ends by cross-portions or end pins 42a and 42b, resulting in a generally box-like configuration as seen in Figure 6. Arm portions 40 are slightly angled, as at 44, and define a hinge or pivot recess 46 on one side of the lever. Arms 40 are spaced by end pins 42a and 42b at least a distance slightly greater than the width of body portion 18 of header connector housing 12.

Eject lever 14 is assembled to header connector housing 12 as best seen in Figure 1 and 4. When assembled, pivot recesses 46 in arms 40 of the lever arm engage a pair of pivot bosses 48 molded integrally with opposite sides (the top and bottom as viewed in Figure 4) of body portion 18 of header connector housing 12, whereby the ejecting lever can pivot in the direction of double-headed arrow "E" (Fig. 2).

Eject lever 14 is assembled to header connector housing 12 by spreading arm portions 40 of the lever outwardly in the direction of arrows "F" (Fig. 6), so that the arm portions can snap behind pivot bosses 48 as seen in Figure 2. This is effected due to the resiliency of the integrally molded ejecting lever. The arm portions thereby sandwich body portion 18 of the header connector housing therebetween. When the eject lever is assembled to header connector housing 12, as described above, end pin 42a of the lever is engageable with drive end 32 of actuating push-rod 16 outside the header connector housing as seen in Figure 1. The opposite end pin 42b of ejecting lever 14 is positioned in a slot 50 in header connector housing 12 whereby the pin is freely movable within the slot as the eject lever moves or pivots in the direction of arrow "E" about pivot bosses 48 on the housing.

In operation, when a memory card or IC pack "C" is inserted or loaded into the header connector housing in the direction of arrow "A" (Fig. 2), as described above, a corner of the IC pack engages end pin 42b of ejecting lever 14 and biases the lever about pivot bosses 48 to the position shown in Figure 1. In this loaded condition, the terminal means on the IC pack are in mating interengagement with terminals pins 24b of the header connector.

When it is desired to eject IC pack "C" from header connector 11, and with reference to Figure 7, a user pushes on push-button 30 of push-rod 16 in the direction of arrow "D". Drive end 32 of the push-rod, being in engagement with end pin 42a of ejecting lever 14, causes the lever to pivot in the direction of arrows "H" about pivot bosses 48. The opposite end pin 42b of the ejecting lever moves in slot 50 and, being in engagement with the inner end of IC pack "C", causes the IC pack to be ejected from the header connector at least to the extent of disengaging the terminals of the IC pack from terminal pins 24b of the header connector.

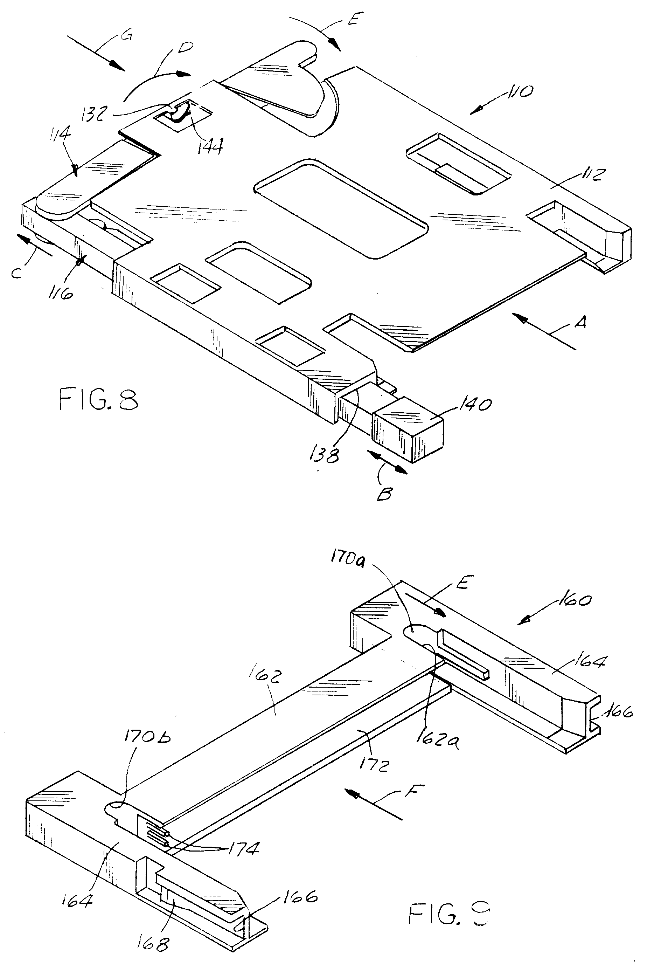

Figure 8 shows a second embodiment of the invention comprehending a three-part ejector mechanism, generally designated 110. The mechanism is designed for mounting to a header connector into which an IC pack is loaded and from which it is ejected. The header connector is shown in Figure 9 and will be described in greater detail hereinafter.

Generally, ejector mechanism 110 includes a first part in the form of a housing, generally designated 112; a second part in the form of a one-piece ejecting lever, generally designated 114; and a third part in the form of a one-piece actuating push-rod, generally designated 116. Each of housing 112, lever 114 and push-rod 116 is individually and integrally molded of dielectric material such as plastic or the like. No other extraneous components are required to assemble or to operate the mechanism.

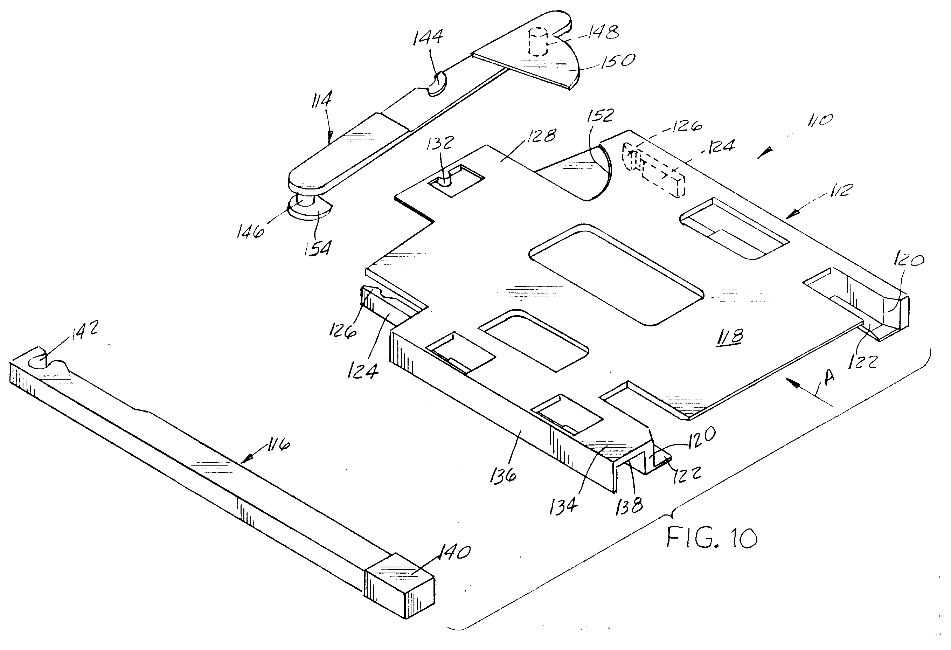

Referring to Figure 10 in conjunction with Figure 8, housing 112 is unitarily molded of plastic and includes a generally planar main wall portion 118 and two depending side walls 120. The side walls terminate in one pair of inwardly directed flanges 122 whereby the opposing pairs of side walls and inwardly directed flanges define inwardly directed channels into which an IC pack or memory card (not shown) is inserted into the housing in the direction of arrow "A".

Housing 112 further includes a pair of resilient cantilevered latch arms 124 which form continuations of side walls 120, each latch arm including an inwardly directed latch hook 126. The latch arms and latch hooks are provided within the housing to allow retention to a header connector (Fig. 9) mounted to a printed circuit board, all of which will be described hereinafter.

Still further, housing 112 includes a rearwardly projecting flange portion 128 which forms a continuation of top wall 118. The flange portion has a cut-out area 130, with a pivot boss 132 projecting into the cut-out area. This structure is provided for pivotally mounting ejecting lever 114, as will be described hereinafter. Top wall 118 also has a flange portion 134 which forms a continuation of the top wall and protrudes outwardly from one side of the top wall, with a downwardly depending outside wall 136 extending along the side edge of the flange portion approximately parallel to one sidewall 120. Outside wall 136 is connected to sidewall 120 by way of two connecting webs (not shown) which lie approximately parallel to top wall 118. Outside wall 136, sidewall 120, top wall 118 and the two connecting webs define a channel 138 within which push-rod 116 is reciprocally movable.

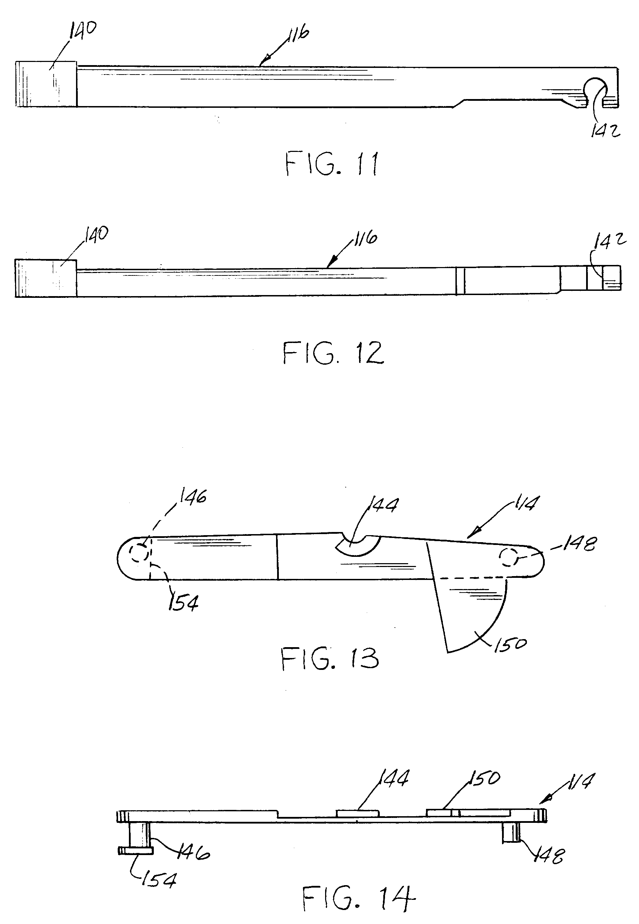

Referring to Figures 11 and 12 in conjunction with Figures 8 and 10, actuating push-rod 116 includes a head portion or push-button 140 at one end thereof and a transverse keyhole-shaped hinge slot 142 at the opposite end thereof. The slot forms part of a complementary interengaging drive means between the push-rod and ejecting lever 114, as will be seen below. As illustrated in Figure 8, push-rod 116 is positioned in channel 138 of housing 112 whereby push-button 140 is exposed at the front of the housing and the opposite or slotted end of the push-rod projects out of the rear of the housing for complementary interengagement with ejecting lever 114.

Referring to Figures 13 and 14 in conjunction with Figures 8 and 6, ejecting lever 114 has an arcuately shaped fulcrum boss 144 intermediate the ends of the lever, a downwardly depending hinge pin 146 at one end of the lever, and a downwardly depending ejecting peg 148 at the opposite end of the lever. A fan-shaped stabilizing flange 150 projects from the top of the lever for positioning in a fan-shaped cut-out 152 in the top of wall portion 118 of housing 112. Lastly, a transverse positioning flange 154 is provided at the bottom of hinge pin 146 at the one end of the lever.

In assembly, and comparing the exploded view of the three-part ejector mechanism shown in Figure 10 with the assembled mechanism shown in Figure 8, push-rod 116 simply is located in channel 138 of housing 112 whereby the push-rod is reciprocally, axially movable relative to the housing in the direction of arrow "B" (Fig. 8). Either before or after the push-rod is located in channel 138, ejecting lever 114 is assembled to the housing. In assembly, the lever is positioned so that fulcrum boss 144 projects upwardly in cut-out 130 of the housing whereby the arcuate shape of the fulcrum boss embraces pivot boss 132 within the cut-out. With the lever underlying flange 128 of the housing, stabilizing flange 150 of the lever positions into cut-out 152 in the top of main wall portion 118 of the housing. Therefore, the lever is maintained in a vertically stabilized position by the lever underlying flange portion 128 of the housing and stabilizing flange 150 of the lever overlying the top wall of the housing in cut-out 152 thereof. In essence, pivot boss 132 of the housing and fulcrum boss 144 of the lever provide complementary interengaging motion transmitting means between the two parts.

The assembly is completed by snapping hinge pin 146 which depends from the one end of ejecting lever 114 into hinge slot 142 at the rear end of actuating push-rod 116. As stated above, hinge slot 142 is keyhole-shaped so that it provides a mouth by which hinge pin 146 can be snap-fit into the slot. When the push-rod and lever are assembled, the one end of the lever, surrounding hinge pin 146, overlies the inner end of the push-rod, and flange 154 at the bottom of hinge pin 146, underlies the push-rod so that the push-rod is sandwiched therebetween.

In operation, when actuating push-rod 116 is moved axially in the direction of arrow "C" (Fig. 8), ejecting lever 114 will pivot in the direction of arrow "D", about pivot boss 132 and fulcrum boss 144, to drive the free end of the lever in the direction of arrow "E".

Referring back to Figure 9, a header connector, generally designated 160, includes a transverse elongated body portion 162 and two side wings 164. The side wings have outside channels 166 in which a pair of outwardly projecting ramped latch bosses 168 are integrally molded. Slots 170a and 170b are formed in side wings 164 outside the ends of body portion 162. In other words, an open area is afforded beyond the opposite ends 162a of the body portion. The body portion also has a card-receiving slot 172 running the length thereof. Although only two pins are shown in Figure 9, a high density plurality of terminal pins 174 are mounted within body portion 162 and extend into slot 172. When a memory card or IC pack is loaded into header connector 160, it is loaded in the direction of arrow "F", into slot 172 whereupon appropriate terminal means on the IC pack interengage with terminal pins 174 of the header connector. It should be noted that when the IC pack is loaded into slot 172 into electrical interengagement with terminal pins 174, it extends to bottom side wings 164, thereby covering the opening of slot 170a into which eject peg 148 of eject lever 114 is positioned.

Referring to Figure 9 in conjunction with Figure 8, ejector mechanism 10 is mounted in header connector 160 in the direction of arrow "F" (Fig. 8). When fully mounted in the header, ramped latch bosses 168, located within side channels 166 of header connector 160, snap behind latch hooks 126 on the distal ends of resilient latch arms 124 to hold the housing 112 of the ejector mechanism within the header connector 160. When so mounted, ejecting pin 148 which depends from the underside of ejecting lever 114 will become seated in the bottom or base of slot 170a in the one side wing 164 of the header connector. The assembled ejector mechanism and header connector now are ready for receiving an IC pack which is to be loaded into slot 172 of the header connector.

When it is desired to eject or unload the IC pack from header connector 160, actuating push-rod 116 simply is pushed in the direction of arrow "C" (Fig. 8). Before proceeding further, it should be remembered that, as noted above, the IC pack extends substantially entirely between side wings 164 of body portion 162 of header connector 160 covering slot 170a in one of the side wings of the header connector. Therefore, ejecting peg 148 of ejecting lever 114 is located in slot 170a "behind" the IC pack. With this understanding, as actuating push-rod 116, is moved in the direction of arrow "C", and ejecting lever 114 is pivoted in the direction of arrow "D", ejecting peg 148 will move in the direction of arrow "E". This directional arrow "E" is also depicted in Figure 9, so that it can be better understood that the ejecting peg will engage one corner of the IC pack and eject the IC pack from the header connector.

From the foregoing, it can be understood that an extremely simple ejector system has been provided in the form of a three-part ejector mechanism. Each of the three parts, namely the housing (12,112), the ejecting lever (14, 114) and actuating push-rod (16,116) is unitarily and integrally molded of dielectric material such as plastic or the like. The interengaging means between the three parts, are provided by integrally molded features on each part. No other extraneous parts are required. The IC pack is ejected from the header connector by a portion of the ejecting lever which is an integrally molded component of the lever, requiring no additional ejecting components.

It will be understood that the invention may be embodied in other specific forms without departing from the spirit or central characteristics thereof. The present examples and embodiments, therefore, are to be considered in all respects as illustrative and not restrictive, and the invention is not to be limited to the details given herein. For example, either ejecting lever (14,114) may be adapted for use in either embodiment.

## Claims

1. A connector apparatus for providing an interconnection between an IC pack and a printed circuit board, including
a plurality of terminals (174) adapted for interconnection of the IC pack to electrical traces on the printed circuit board,
a housing (112) having an IC pack receiving opening and an integrally formed channel (138) therein,
said IC pack being inwardly and outwardly movable within the housing between an inserted position wherein it electrically mates with the terminals and an ejected position wherein a portion of the IC pack extends outside the opening,
an ejector mechanism (110) for selectively moving an inserted IC pack from the inserted position to the ejected position, said ejector mechanism having
an ejector arm pivotally mounted on the housing adapted to effect movement of the IC pack to the ejected position, and
a manually manipulatable actuator (116) slidably mounted in said channel for movement in the same general direction as the insertion and ejection of the IC pack and adapted to cooperate with said ejector arm in moving the IC pack outwardly to the ejected position,
characterized in that:
said ejector arm defines a lever (114) pivotally mounted intermediate opposite ends thereof, having a first end for engaging said actuator and a second end for engaging the IC pack when said pack is in the inserted position; and
said connector apparatus further includes a dielectric header (160) separate from said housing,
said terminals (174) being mounted in said header (160),
said housing having integrally molded latches (124) for removably latching said housing to said header and for mounting said ejector mechanism for movement therewith
whereby when said housing is latched to the header, said IC pack is in the inserted position and the actuator is moved inwardly, the second end of the ejector arm moves the IC pack outwardly to the ejected position.

2. The connector apparatus of claim 1, further including a stabilizing flange (150) integrally molded on said lever (114) and engageable with a cut-out portion (152) of the housing for stabilizing pivotal movement of the lever.

3. The connector apparatus of claim 1, wherein said lever includes a fulcrum boss (144) for pivotally mounting to an integrally molded pivot boss (132) on the housing.

4. The connector apparatus of claim 1, wherein said lever is elongated and includes a pair of generally parallel spaced apart arm portions (40) mounted on said header, whereby said header is sandwiched therebetween.

5. The connector apparatus of claim 4, wherein said lever further includes pivot recesses (46) interengageable with integrally molded pivot bosses (48) on the housing.

6. The connector apparatus of claim 1, wherein said lever includes an integrally molded ejecting pin (148) adapted to engage a corner of the IC pack to effect ejection of the IC pack.
